# EUROPEAN PATENT SPECIFICATION

(11) **EP 0 267 513 B1**
(45) Date of publication and mention of the grant of the patent: **12.08.1998**
(21) Application number: 87116091.7
(22) Date of filing: 02.11.1987
(51) Int. Cl.: H01J 37/32, C23C 16/50

(54) **Microwave enhanced CVD method and apparatus**
Durch Mikrowellen gesteigertes CVD-Verfahren und -Gerät
Méthode et appareil de CVD assistée par micro-ondes

(30) Priority: 10.11.1986 JP 266834/86; 05.01.1987 JP 298/87
(43) Date of publication of application: 18.05.1988
(73) Proprietor: SEMICONDUCTOR ENERGY LABORATORY CO., LTD., Atsugi-shi Kanagawa-ken, 243 (JP)
(72) Inventor: Inujima, Takashi, Atsugishi Kanagawa 243-01 (JP); Hirose, Naoki, Atsugi-shi Kanagawa, 243 (JP); Tashiro, Mamoru, Tokyo 157 (JP); Yamazaki, Shunpei, Tokyo 157 (JP)
(74) Representative: Grünecker, Kinkeldey, Stockmair & Schwanhäusser Anwaltssozietät

(56) References cited:
- EP-A- 46 945
- US-A- 4 401 054
- US-A- 4 559 100
- JAPANESE JOURNAL OF APPLIED PHYSICS, vol. 26, no. 6, June 1987, pages L1032-L1034, Tokyo, JP; H. KAWARADA et al.: "Large area chemical vapour deposition of diamond particles and films using magneto-microwave plasma"

## Description

This invention relates to a microwave enhanced plasma chemical deposition method and apparatus in accordance with claims 1 and 13.

From US 44 01 054, such a conventional ECR equipment is already known, whereby a plasma formation chamber and a specimen chamber are arranged separately. Gaseous material and microwave power are introduced to the plasma formation chamber to generate plasma by a microwave discharge through electron cyclotron resonance. The plasma is extracted to the specimen chamber.

Document US-A-4 559 100 discloses a CVD apparatus comprising a microwave generator, magnet means, and a substrate holder that is placed in the discharge region. The object of the prior art apparatus is to increase the etching speed by narrowing the gap between stage 14 and the discharge tube. As a result, the effective pumping speed for the particles decreases, thereby increasing the residence time of the reactive particles.

Recently, ECR CVD has attracted the interests of researchers as a new method of manufacturing thin films, particularly amorphous thin films. As already explained, Matsuo et al discloses one type of such a ECR CVD apparatus in USP 4,401,054. This recent technique utilizes microwaves to energize a reactive gas into a plasma state by virtue of a magnetic field which functions to pinch the plasma gas within the excitation space. With this configuration, the reactive gas can absorb the energy of the microwaves. A substrate to be coated is located distant from the excitation space (resonating space) for preventing the same from being spattered. The energized gas is showered on the substrate from the resonating space. In order to establish an electron cyclotron resonance, the pressure in a resonating space is kept at (1 x 10⁻³ to 1 x 10⁻⁵ Torr) 0,13 - 0,13·10⁻² Pa at which electrons can be considered as independent particle and resonate with a microwave in an electron cyclotron resonance on a certain surface on which the magnetic field takes a particular strength required for ECR. The excited plasma is extrated from the resonating space, by means of a divergent magnetic field, to a deposition space which is located distant from the resonating space and in which is disposed a substrate to be coated.

In such a prior art method, it is very difficult to form a thin film of a polycrystalline or single-crystalline structure, so that currently available methods are almost limited to processes for manufacturing amourphous films. Also, high energy chemical vapor reaction is difficult to take place in accordance with such a prior art and therefore a diamond film or other films having high melting points, or uniform films on an even surface having depressions and caves can not be formed.

It is therefore an object of the invention to provide a microwave enhanced CVD method and an apparatus therefor capable of forming a film, which can not be formed by prior art, such as a diamond film, or a film of a material having a high melting point and to provide processes with a highly densed plasma on the surface of the substrate. This object is met by the characterizing features of claims 1 and 13.

According to one aspect of the invention, the surface of an object to be processed is located in a region of a resonating space in which electric field of a microwave takes its maxmum value. By this configuration, the deposition can be carried out while the deposited film is being partially sputtered, and therefore, e.g., a diamond film can be formed.

According to another aspect of the invention, a new CVD process has been culminated. The new process utilizes a mixed cyclotron resonance which was dirived firstly by the inventors. In the new type of exciting process, interaction of reactive gas itself must be taken into consideration as a non-negligible perturbation besides magnetic field and microwave, and therefore charged particles of a reactive gas can be absorbed in a relatively wide resonating space. For the mixed resonance, the pressure in a reaction chamber is elevated 10²-10⁵ times as high as that of prior art.

Fig.1 is a cross section view showing a CVD apparatus in accordance with the present invention.

Fig.2(A) is a graphical diagram showing the plofile of the equipotential surfaces of magnetic field in cross section.

Fig.2(B) is a graphical diagram showing the strength of electric field.

Figs.3(A) and 3(B) are graphical diagrams showing equipotential surfaces in terms of magnetic field and electric field respectively.

Fig.4 is a cross section view showing another embodiment in accordance with the present invention.

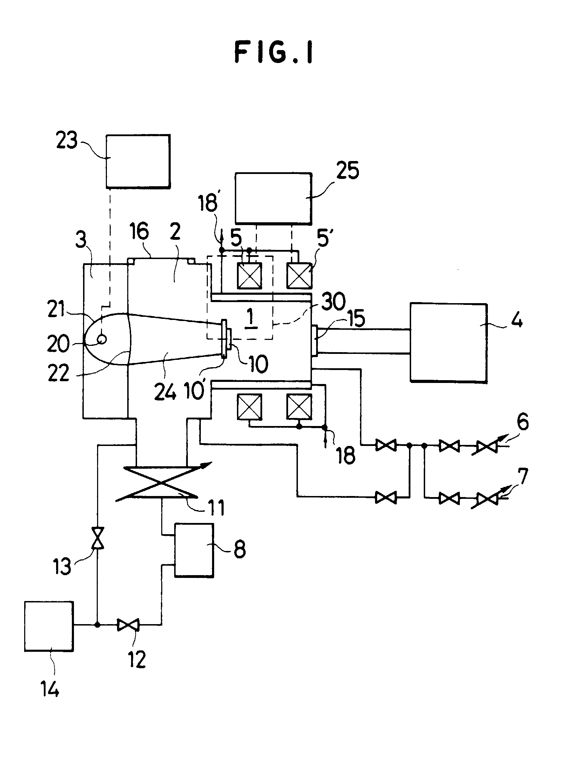

Referring to Fig.1, a microwave enhanced plasma CVD apparatus in accordance with the present invention is illustrated. In the figure, the apparatus comprises a reaction chamber in which a plasma generating space 1 and an auxiliary space 2 are defined and can be held at an appropriate pressure, a microwave genarator 4, electro-magnets 5 and 5' in the form of solenoids surrounding the space 1, a power supply 25 for supplying and elecric power to the electro-magnets 5 and 5', and a water cooling system 18. The plasma generating space 1 has a circular cross section. In the plasma generating space 1, a substrate holder 10' made of a highly thermal conductive ceramic such as alminium nitride is provided on which a substrate 10 is mounted. The substrate holder 10' is irradiated and heated to 150-1000°C with an infrared light 24, which is emitted from an IR heater 20, reflected from an IR reflection parabola mirror 21 and focused on the back surface of the holder 10' through a lens 22. A reference numeral 23 designates a power supply for the IR heater 20. Provided for evacuating the reaction chamber is an evacuating system comprising a turbo molecular pump 8 and a rotary pump 14 which are connected with the reaction chamber through pressure controlling valves 11, 12 and 13. The substrate temperature may reach a sufficient value only with the plasma gas generated in the reaction chamber. In the case, the heater can be dispensed with. Further, depending on the condition of the plasma, the substrate temperature might elevate too high to undergo a suitable reaction. In the case, cooling means has to be provided. The process with this apparatus is carried out as follow.

A substrate 10 is mounted on the substrate holder 10' and heated by infrared light 24 to 500°C. Then, hydrogen gas is introduced from a gas introducing system 6 at 10 SCCM, and a microwave of 1 GHz or stronger, e.g., 2.45GHz is emitted from the microwave generator thorugh a microwave introduction window 15 to the plasma generating space 1 which is subjected to an magnetic field of about (2 K Gauss) 2·10⁻¹ T induced by the magnets 5 and 5'. The hydrogen is excited in a high density plasma state in the space 1 by the energy of the microwave. The surface of the substrate is cleaned by high energy elecrons and hydrogen atoms. In addition to the introduction of the hydrogen gas, C₂H₂ and CH₄ are inputted through a introduction system 7, and excited by the energy of microwave at (1-800 Torr) 133,3 - 106,7·10³ Pa in the same manner as carried out with hydrogen explained in the foregoing description. As a result of a chemical vapor reaction, carbon is deposited in the form of a diamond film or an i-carbon (insulated carbon) film. The i-carbon is comprised of a mixture of diamond and amorphous carbon.

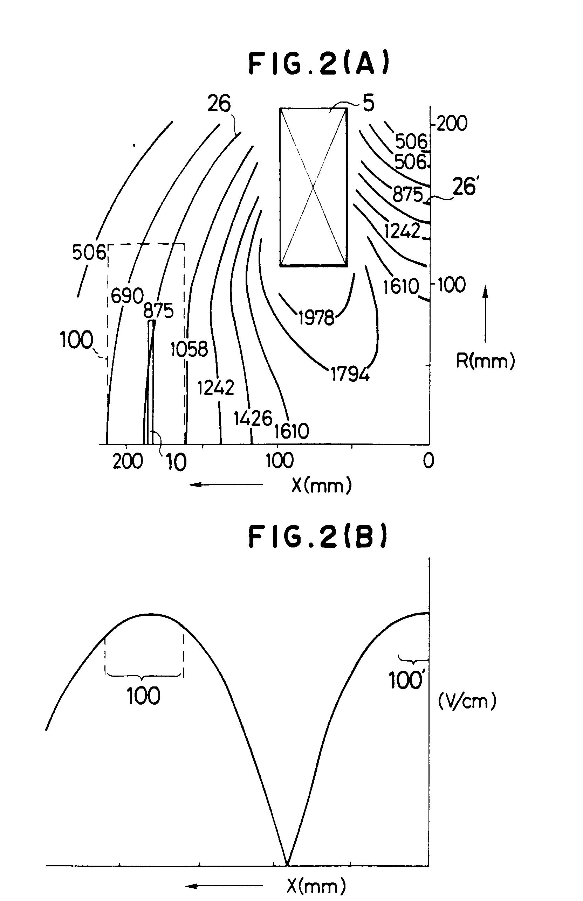

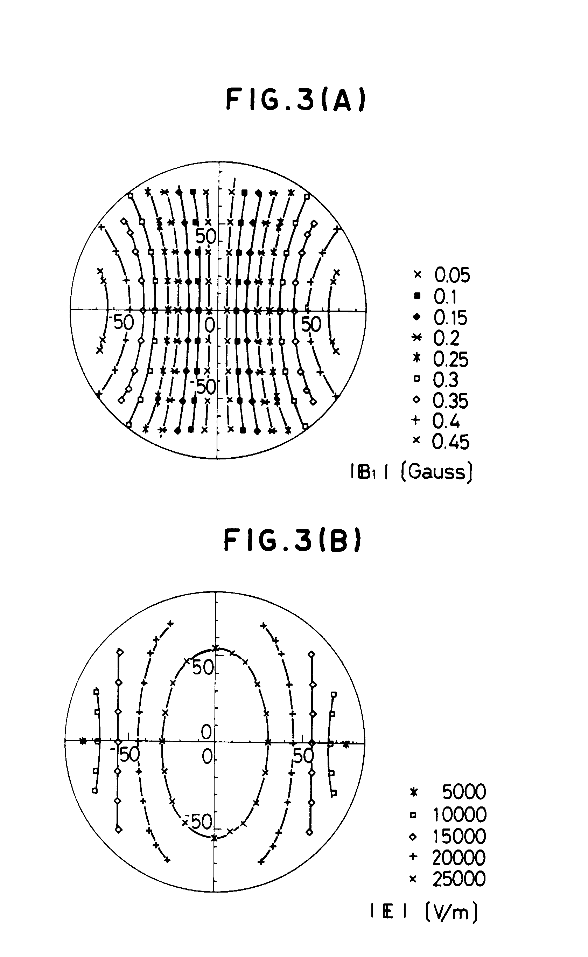

Fig.2(A) is a graphical diagram showing the distribution of magnetic field on the region 30 in Fig.1. Curves on the diagram are plotted along equipotential surfaces and marked with the strength values of the magnetic field induced by the magnet 5 having a power of (2000 Gauss) 2·10⁻¹ T. By adjusting the power of the magnets 5 and 5', the strength of the magnetic field can be controlled so that the magnetic field becomes largely uniform over the surface to be coated which is located in the region 100 where the magnetic field (875±185 Gauss) 8,75·10⁻² T and the electric field interact. In the diagram, a reference 26 designates the equipotential surface of (875 Gauss) 8,75·10⁻² T at which ECR (electron cyclotron resonance) condition between the magnetic field and the frequency of the microwave is sutisfied. Of course, in accordance with the present invention, ECR can not be establised due to the high pressure in the reaction chamber,(1-800 Torr), 133,3-106,7 · 10³ Pa but instead a mixed cyclotron resonance (MCR) takes place in a broad region including the equipotential surface of the ECR condition. Fig.2(B) is a graphical diagram corresponding to Fig.2(A) and shows the strength of electric field of the microwave in the plasma generating space 1. The strength of the electric field takes its maximum value in the regions 100 and 100'. However, in the region 100', it is difficult to heat the substrate 10' without disturbing the propagation of the microwave. In other region. a film is not uniformly deposited, but deposited the product in the form of a doughnut. It is for this reason that the substrate 10 is disposed in the region 100. The plasma flows in the lateral direction. According to the experimental, a uniform film can be formed on a circular substrate having a diameter of less than 100mm. Preferably, a film is formed in the chamber on a circular substrate having a diameter of less than 50mm with a uniform thickness and a uniform quality. When a larger substrate is desired to be coated, the diameter of the space 1 can be double by making use of 1.225 GHz as the frequency of the microwave. Figs.3(A) and 3(B) are graphical diagrams showing the distributions of the magnetic field and the electric field on a cross section of the plasma generating space 1. The curves ploted in the circles of the figures correspond equipotential surfaces. As shown in Fig.3(B), the electric field reaches its maxmum value at 25 KV/m.

The diffraction images of films formed in accordance with the present invention were obtained. As results, halo patterns were obserbed together with spots indicating the existence of diamond. The halo patterns gradually, which corresponds to an amorphous state, disappear as the substrate temperature elevates, and when the temperature rises beyond 650°C the film became a diamond. At less than 150°C, i-carbon film could not be formed. For reference, a film formation process was performed in the same manner as in the above but without using a magnetic field. As a result, a graphite film was deposited.

In the same manner, polycrystalline silicon carbide films, and aluminium nitride films can be formed by making use of methyl silane, and alminium compound gas and ammonia gas respectively as a reactive gas. Further, other films having high melting points of tungsten, titanium, molybdenum or their silicon compounds can be formed in the similar manner.

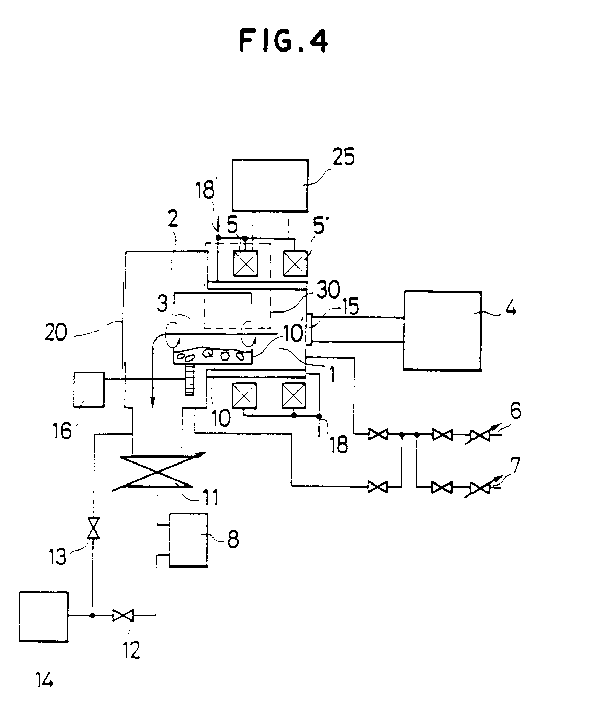

Referring to Fig.4, another embodiment of the invention is illustrated. In the figure, the apparatus comprises a reaction chamber in which a plasma generating space 1 and an auxiliary space 2 are defined and can be held at an appropriate pressure, a microwave genarator 4, electro-magnets 5 and 5' which are supplied with electric power from a power supply 25, and a water cooling system 18. The plasma generating space 1 has a circular cross section. In the plasma generating space 1, a hollow cylinder 10' having inward-turned brims is rotatably supported in the space so that a microwave emitted from the microwave genarator 4 passes through the cylinder along its axis. The cylinder 10' is made of a stainless steel or a quartz and turned by means of a motor 16 through a gear. Provided for evacuating the reaction chamber is a evacuating system comprising a turbo molecular pump 8 and a rotary pump 14 which are connected with the reaction chamber through pressure controlling valves 11, 12 and 13. The process with this appratus is carried out as follow.

Objects 10 to be coated, for example, metallic, plastic, ceramic parts (such as gears, screws, ornament jigs, or microparticles for grinding) are put in the cylinder 10' and turned at 0.1-10 rpm during process. The cylinder 10', although the means is not illustrated in the figure, is shaken by micro-vibration of 100Hz-10KHz. By the turning and the vibration, the surfaces of the objects exposed to the surrounding are always switching during process. The reaction chamber is evacuated by the turbo molecular pump 8 and the rotary pump to (1 x 10⁻⁶ Torr) 0,13·10⁻³ Pa or lower. Then, argon, helium or hydrogen as a non-productive gas is introduced to the reaction chamber from a gas introducing system 6 at 30SCCM, and a microwave of 2.45GHz is emitted from the microwave generator at 500 W through a microwave introduction window 15 to the plasma generating space 1 subjected to an magnetic field of about (2 K Gauss) 2·10⁻¹ T induced by the magnets 5 and 5'. The pressure of the non-productive gas is (1 x 10⁻⁴ Torr) 0,013 Pa. A plasma is generated in the space 1 at a high density by the energy of the microwave. The surfaces of the objects 10 is cleaned by high energy elecrons and non-productive atoms. In addition to the introduction of non-productive gas, C₂H₂, C₂H₄ and/or CH₄ are introduced through a introduction system 7 at (1-800 Torr) 133,3 - 106,7·10³ Pa preferably (3-30 Torr) 400 - 4000 Pa e.g., (10 Torr) 1333,2 Pa, and excited by the energy of microwave in the same manner as carried out with the non-productive gas explained in the foregoing description. As a result of a mixed resonance, carbon is deposited in the form of a diamond film or an i-carbon film on the objects 10. In this embodiment, a heating means as illustrated in Fig.1 may be used as in Fig.1.

The distributions of magnetic field and electric field are same as Figs.2(A), 2(B), 3(A) and 3(B) explained in conjunction with the preceding embodiment, and therefore redundant description is dispensed with.

The diffraction images of films formed in accordance with the present invention were obtained. As results, halo patterns were obserbed together with spots indicating the existence of diamond. The halo patterns gradually disappear as the substrate temperature elevates, and when the temperature rises beyond 650°C the film became a diamond. At less than 150°C, i-carbon film could not be formed. For reference, a film formation process was performed in the same manner as in the above but without using a magnetic field. As a result, a graphite film was deposited.

In the same manner, polycrystalline silicon carbide films, and aluminium nitride films can be formed by making use of methylsilane, and alminium compound gas and ammonia gas respectively as a reactive gas. Further, other films having high melting points of tungsten, titanium, molybdenum or their silicon compounds can be formed in the similar manner. For example, a BN or BP film could be formed in accordance with the present invention.

The pressure in the reaction chamber is chosen at that required for ECR condition, so that a preliminary plasma discharge takes place. While the discharge continues, the pressure is changed to (1 Torr to 3 x 10³ Torr) (133,32 Pa - 4·10⁵ Pa) where a mixed resonance takes place with a plasma of which particles have a mean free path of 0.05 mm to several milimeters, normally not more than 1 mm.

The process proposed by this invention is suitable for manufacturing superconductig ceramics including one or more rare earth elements, one or more alkaline earth element (including Be and Mg) and Cu. In this case, a process gas is prepared by bubbling a solution of compounds of the elements with oxygen gas. For example, an organic solution (benzene, or alcohol solution) or a water solution of alkvlenes or halides of Y(OC₂H₅)₃, Ba(OC₂H₅)₃ and CuBr₃ so that the stoichometric ratio among Y, Ba and Cu is 1:2:3. The stoichometric formula of the deposited product is YBa₂Cu₃O₆₋₈. In place of bubbling method, compounds of the elements can be inputted to the reaction chamber by blowing the compounds in the form of fine powder with a highly pressurized oxgen gas, so called spraying method.

The invention should not limited to the above particular embodiments. For example, instead of the hollow cylinder, any hollow member having a cross section of a polygon can be employed.

## Claims

1. A plasma chemical vapor deposition method comprising the steps of:
inputting a reactive gas into a reaction chamber (1);
emitting a microwave into said reaction chamber at a predetermined frequency;
establishing a magnetic field in said reaction chamber (1) where the strength of the magnetic field is such that it meets with the ECR condition f_{cycl} = (qₑ · B)/mₑ at a position in the reaction chamber where the direction of the magnetic field is substantialy parallel to the direction of propagation of the microwave;
converting said reactive gas to a plasma;
**characterized by**
holding a substrate approximately at said position in the reaction chamber; and
carrying out a chemical vapor reaction on said substrate to be processed with said plasma.

2. The method of claim 1, wherein the excitation frequency is 2.45 Ghz.

3. The method of claim 2, wherein the strength of the magnetic field at said position where the substrate is located is 8.75 10⁻²T ± 1.85 10⁻²T.

4. The method of claim 1, wherein said reactive gas comprises at least one hydrocarbon.

5. The method of claim 4, wherein the temperature of the substrate for depositing a diamond layer is higher than 650°C.

6. The method of claim 4, wherein said reactive gas is C₂H₆, C₂H₄, and/or C₂H₂.

7. The method of claim 4, wherein said reactive gases CH₄.

8. The method of claim 1, whereby the pressure of the reactive gas is kept between 133 - 106.6 x 10³ Pa during the process.

9. The method of claim 8, wherein said pressure is chosen between 400 and 4000 Pa.

10. The method of claim 1, wherein the strength of said magnetic field is 0.1 T or stronger.

11. The method of claim 7, wherein said reactive gas is prepared by oxygen bubbling of an organic solution of components, which constitute a precursor for superconducting material.

12. The method of claim 11, wherein said solution is an organic solution of Y(OC₂H₅)₃, Ba(OC₂H₅)₃, and CuBr₃.

13. A plasma chemical vapor deposition apparatus for carrying out the method of claim 1, comprising:
a reaction chamber (1);
a gas feeding system (6,7) for inputting a reactive gas into said reaction chamber (1);
a microwave generator (4) for emitting a microwave into said reaction chamber at a predetermined frequency through a window;
means (5,5') for establishing a magnetic field in said reaction chamber where the direction of the magnetic field is substantially parallel to the direction of propagation of the microwave and the strength of the magnetic field is such as to meet with the ECR condition f_{cycl} = (qₑ · B)/mₑ at a position in the reaction chamber
means for exhausting (8,14) the reaction chamber to establish a predetermined pressure range in the chamber;
**characterized by**
means for locating a substrate (10) substantially at said position in the reaction chamber.

14. The apparatus of claim 1, further comprising means (20) for controlling the temperature of said object.

15. The apparatus of claim 14, wherein said controlling means is an infrared heater (20).

16. The apparatus of claim 15, wherein said heater irradiates said holding means (10') with infrared light.

17. The apparatus of claim 16, wherein said infrared light is focused on said holding means.

18. The apparatus of claim 17, wherein said resonating space (1) is surrounded by a cylindrical wall.

19. The apparatus of claim 18, wherein said magnet (5,5') is a solenoid encircling the outer side of said cylindrical wall.

20. The method of claim 4, wherein the temperature of the substrate for depositing an i-carbon layer is higher than 150°C.

21. The apparatus of claim 13, wherein the strength of the magnetic field decreases along a line extending through said substrate in the direction of propagation of the microwave.

22. An apparatus as in claim 21, wherein the exhausting means comprises a turbo-molecular pump (8).

23. An apparatus as in claim 21, wherein said substrate is supported by a substrate holder.

## Patentansprüche

1. PECVD Verfahren, das die Schritte umfaßt:
Einbringen eines reaktiven Gases in eine Reaktionskammer (1);
Emittieren einer Mikrowelle in die Reaktionskammer mit einer bestimmten Frequenz;
Erzeugen eines Magnetfeldes in der Reaktionskammer (1), wobei die Stärke des Magnetfelds so ist, daß sie die ECR Bedingung f_{cycl}=(qₑ x B)/mₑ an einer Position in der Reaktionskammer erfüllt, wo die Richtung des Magnetfelds im wesentlichen parallel zur Richtung der fortschreitenden Mikrowelle ist;
Überführen des reaktiven Gases in ein Plasma
**gekennzeichnet durch**
Halten eines Substrats an dieser Position in der Reaktionskammer und
Durchführen einer chemischen Dampfreaktion mit dem Plasma auf dem Substrat das prozessiert werden soll.

2. Verfahren nach Anspruch 1, wobei die Anregungsfrequenz 2,45 GHz ist.

3. Verfahren nach Anspruch 2, wobei die Stärke des Magnetfelds an der Position wo das Substrat angeordnet ist, 8,75 x 10⁻² T ± 1,85 x 10⁻² T beträgt.

4. Verfahren nach Anspruch 1, wobei das reaktive Gas zumindest einen Kohlenwasserstoff umfaßt.

5. Verfahren nach Anspruch 4, wobei die Temperatur des Substrats zum Abscheiden einer Diamantschicht höher als 650°C ist.

6. Verfahren nach Anspruch 4, wobei das reaktive Gas C₂H₆, C₂H₄ und/oder C₂H₂ ist.

7. Verfahren nach Anspruch 4, wobei das reaktive Gas CH₄ ist.

8. Verfahren nach Anspruch 1, wobei der Druck des reaktiven Gases zwischen 133 bis 106,6 x 10³ Pa während des Prozess gehalten wird.

9. Verfahren nach Anspruch 8, wobei der Druck zwischen 400 und 4000 Pa gewählt wird.

10. Verfahren nach Anspruch 1, wobei die Stärke des Magnetfelds 0,1 T oder stärker ist.

11. Verfahren nach Anspruch 7, wobei das reaktive Gas durch "Bubbeln" von Sauerstoff durch eine organische Lösung von Komponenten, die einen Precursor für superleiffähiges Material darstellen, hergestellt wird.

12. Verfahren nach Anspruch 11, wobei die Lösung eine organische Lösung von Y(OC₂H₅)₃, Ba(OC₂H₅)₃ und CuBr₃ ist.

13. PECVD Apparat zur Durchführung des Verfahrens nach Anspruch 1, umfassend:
eine Reaktionskammer (1);
eine Gaszuleitung (6,7) zum Einbringen eines reaktiven Gases in die Reaktionskammer 1;
einen Mikrowellengenerator (4) zum Emittieren einer Mikrowelle in die Reaktionskammer bei einer bestimmten Frequenz durch ein Fenster;
eine Einrichtung 5,5' zur Erzeugung eines Magnetfelds in der Reaktionskammer, wobei die Richtung des Magnetfelds im wesentlichen parallel zur Fortschreitrichtung der Mikrowelle ist und die Stärke des Magnetfelds so ist, daß sie die ECR-Bedingung f_{cycl} = (qₑ x B)/mₑ an einer Position in der Reaktionskammer erfüllt,
eine Einrichtung zum Auspumpen (8,14) der Reaktionskammer um einen bestimmten Druckbereich in der Kammer herzustellen;
**gekennzeichnet durch** eine Einrichtung zum Lagern eines Substrats (10) im wesentlichen an dieser Position in der Reaktionskammer.

14. Apparat nach Anspruch 1, der weiter eine Einrichtung (20) zum Steuern der Temperatur des Objekts einschließt.

15. Apparat nach Anspruch 14, wobei die Steuereinrichtung eine Infrarotheizung (20) ist.

16. Apparat nach Anspruch 15, wobei die Heizung den Halter (10') mit Infrarotlicht bestrahlt.

17. Apparat nach Anspruch 16, wobei das Infrarotlicht auf den Halter fokussiert wird.

18. Apparat nach Anspruch 17, wobei der Resonanzraum (1) durch eine zylindrische Wand umgeben ist.

19. Apparat nach Anspruch 18, wobei der Magnet (5,5') eine Magnetspule ist, die die äußere Seite der zylindrischen Wand umrundet.

20. Verfahren nach Anspruch 4, wobei die Temperatur des Substrats höher als 150°C ist.

21. Apparat nach Anspruch 13, wobei die Stärke des Magnetfelds entlang einer Linie abnimmt, die sich durch das Substrat in Fortschreitrichtung der Mikrowelle erstreckt.

22. Vorrichtung nach Anspruch 21, wobei die Abpumpeinrichtung eine Turbomolekularpumpe (8) umfaßt.

23. Apparat nach Anspruch 21, wobei das Substrat von einem Substrathalter gehalten wird.

## Revendications

1. Procédé de dépôt chimique en phase vapeur par plasma, comprenant les étapes consistant à :
faire entrer un gaz de réaction dans une chambre de réaction (1) ;
émettre des micro-ondes à une fréquence prédéterminée vers ladite chambre de réaction ;
créer un champ magnétique dans ladite chambre de réaction (1), où l'intensité du champ magnétique est telle qu'il remplit la condition ECR f_{cycl} = (qe.B) /mₑ en une position dans la chambre de réaction, où la direction du champ magnétique est sensiblement parallèle à la direction de propagation des micro-ondes ;
transformer ledit gaz réactif en un plasma,
caractérisé en ce que l'on
fait maintenir un substrat sensiblement au niveau de ladite position dans la chambre de réaction ; et
réalise une réaction chimique en phase vapeur sur ledit substrat à traiter avec ledit plasma.

2. Procédé selon la revendication 1, dans lequel la fréquence d'excitation est de 2,45 GHz.

3. Procédé selon la revendication 2, dans lequel l'intensité du champ magnétique au niveau de ladite position où l'on place le substrat est de 8,75.10⁻² T ± 1,85.10⁻²T.

4. Procédé selon la revendication 1, dans lequel ledit gaz de réaction comprend au moins un composé hydrocarboné.

5. Procédé selon la revendication 4, dans lequel la température du substrat pour déposer une couche en diamant est supérieure à 650°C.

6. Procédé selon la revendication 4, dans lequel ledit gaz de réaction est du C₂H₆, C₂H₄ et/ou C₂H₂.

7. Procédé selon la revendication 4, dans lequel ledit gaz de réaction est du CH₄.

8. Procédé selon la revendication 1, dans lequel on garde la pression du gaz de réaction pendant le processus entre 133 - 106,6 x 10³ Pa.

9. Procédé selon la revendication 8, dans lequel on choisi ladite pression entre 400 et 4000 Pa.

10. Procédé selon la revendication 1, dans lequel l'intensité dudit champ magnétique est de 0,1 T ou plus.

11. Procédé selon la revendication 7, dans lequel on prépare ledit gaz de réaction par bullage d'oxygène dans une solution organique de composants, qui constitue un précurseur pour du matériau supraconducteur.

12. Procédé selon la revendication 11, dans lequel ladite solution est une solution organique de Y(OC₂H₅)₃, Ba(OC₂H₅)₃, et CuBr₃.

13. Dispositif de dépôt chimique en phase vapeur par plasma, destiné à mettre en oeuvre le procédé selon la revendication 1, comprenant :
une chambre de réaction (1) ;
un système d'alimentation en gaz (6, 7) destiné à faire entrer un gaz de réaction dans ladite chambre de réaction (1) ;
un générateur de micro-ondes (4) destiné à émettre des micro-ondes à une fréquence prédéterminée vers ladite chambre de réaction au travers d'une fenêtre ;
des moyens (5, 5') destinés à créer un champ magnétique dans ladite chambre de réaction, où la direction du champ magnétique est sensiblement parallèle à la direction de propagation des micro-ondes et l'intensité du champ magnétique est telle qu'il remplit la condition ECR f_{cycl} = (qe.B)/mₑ en une position dans la chambre de réaction ;
des moyens destinés à l'échappement (8, 14) de la chambre de réaction, afin d'établir un intervalle prédéterminé de pression dans la chambre ;
caractérisé par
des moyens destinés à placer un substrat (10) sensiblement au niveau de ladite position dans la chambre de réaction.

14. Dispositif selon la revendication 13, comprenant en outre des moyens (20) destinés à maîtriser la température dudit objet.

15. Dispositif selon la revendication 14, dans lequel les moyens de maîtrise sont un chauffage par infrarouge (20).

16. Dispositif selon la revendication 15, dans lequel ledit chauffage irradie lesdits moyens de maintien (10') avec une lumière infrarouge.

17. Dispositif selon la revendication 16, dans lequel on focalise ladite lumière infrarouge sur lesdits moyens de maintien.

18. Dispositif selon la revendication 17, dans lequel on entoure ledit espace de résonance (1) par une paroi cylindrique.

19. Dispositif selon la revendication 18, dans lequel ledit aimant (5, 5') est un solénoïde entourant le côté extérieur de ladite paroi cylindrique.

20. Procédé selon la revendication 4, dans lequel la température du substrat est supérieure à 150°C, pour déposer une couche en carbone-i.

21. Dispositif selon la revendication 13, dans lequel l'intensité du champ magnétique décroît le long d'une ligne se déployant au travers dudit substrat, dans la direction de propagation des micro-ondes.

22. Dispositif selon la revendication 21, dans lequel les moyens d'échappement comprennent une pompe turbomoléculaire (8).

23. Dispositif selon la revendication 21, dans lequel on fait supporter ledit substrat par un maintien pour substrat.
